# EUROPEAN PATENT APPLICATION

(11) **EP 1 744 352 A2**
(43) Date of publication of application: **17.01.2007**
(21) Application number: 06447038.8
(22) Date of filing: 17.03.2006
(51) Int. Cl.: H01L 21/28, H01L 21/336, H01L 29/49

(54) **Method for forming a fully germano-silicided gate mosfet and devices obtained thereof**

(30) Priority: 11.07.2005 US 698083
(71) Applicant: INTERUNIVERSITAIR MICROELEKTRONICA CENTRUM ( IMEC), 3001 Leuven (BE)
(72) Inventor: Yu, HongYu, 3001 Leuven (BE); Biesemans, Serge, 3000 Leuven (BE)
(74) Representative: pronovem

(57) **Abstract**

A MOSFET comprising a fully germano-silicided gate electrode having a high work function is disclosed.

This gate electrode is formed by a self-aligned reaction process between a silicidation metal and a semiconductor material comprising silicon and germanium.

Preferably, the fully germano-silicided gate is formed by a reaction between nickel and SiGe.

The work function of the fully germano-silicided gate electrode can be tuned.

## Description

### Field of the Invention

The present invention relates to semiconductor process technology and devices. In particular, the present invention relates to semiconductor devices with metallic gate electrodes formed by a reaction between a metal and a semiconductor material.

### Background of the Invention

As the requirements for electronic devices, such as functionality, operation speed and power consumption, are becoming more and more stringent, Complementary-Metal-Oxide-Silicon (CMOS), as it is commercially used today, is faced with the problem of manufacturing smaller devices meeting these requirements. In particular the threshold voltage of the Metal-Oxide-Silicon Field Effect Transistors (MOSFET) device needs to be controllable as this device parameter largely influences the operational speed and power consumption of the MOSFET device.

The scaling of the MOSFET causes manufacturers of electronic devices to replace well-known and widely used materials, such as silicon and silicon-oxide, with novel materials. These novel materials need to be compatible with and easily implemented in a mainstream MOS process flow. Dielectric materials having a dielectric constant larger than silicon-oxide are introduced to form gate dielectric.

Typically, metal oxides, such as HfSiO₂, HfSi, and Al₂O₃, are selected as a high-k dielectric. For the same or smaller equivalent Capacitive Oxide Thickness (COT) (i.e., the thickness of the dielectric layer extracted from capacitive measurements), such high-k dielectrics allow forming a physically thicker layer in comparison with a silicon-oxide. In order to reduce the sheet resistance and the gate depletion effect, metals are considered as replacements for polycrystalline silicon. Metal gate electrodes can be formed by full silicidation (FUSI) of the polysilicon gate electrode with a metal, such as nickel, cobalt, tungsten, and so on. During this silicidation process the complete polysilicon gate electrode is converted into a silicide.

Several problems arise when implementing high-k dielectrics and metals in a MOSFET device. The metal must have the appropriate work function in order to obtain the desired low threshold voltage. The work function should be in the range 4 to 4.2eV if the metal is used to form the gate electrode of an nMOSFET and in the range 5 to 5.2eV when used to form the gate electrode of a pMOSFET. Typically, fully silicided gate electrodes are formed by NiSi, although NiSi has a near-midgap work function resulting in a large threshold voltage for nMOSFET and pMOSFET.

Several methods have been proposed to adjust the work function of the FUSI gate, such as doping of the polysilicon prior the depositing of the nickel, controlling the nickel silicide phase formed at the interface with the gate dielectric, or using a silicidation metal other than nickel. Control of the work function by selecting the phase of the silicide depends on the exact phase formed and the thermal stability thereof, and the use of other silicidation metals, such as Yb, Er, or Pt, can raise metal contamination issues when introduced in a conventional CMOS production environment.

The selected high-k dielectric and metal should not influence the work function of the gate electrode. As reported by C. Hobbs et al. in "Fermi level pinning at the PolySi/Metal Oxide interface," proceedings of the Symposium on VLSI technology 2003 page 9, defects and charges within the gate stack can result in a threshold voltage shift. The interaction between the gate electrode and the gate dielectric will, at their interface, fix the Fermi level to an unwanted value. This phenomenon of Fermi level pinning is known to cause a high threshold voltage for metal gates.

Terai et al discuss in "Highly reliable HfSiON CMOSFET with Phase controlled NiSi (NFET) and Ni3Si (PFET) FUSI gate electrode," proceedings of the Symposium on VLSI technology 2005 pages 68-69, the relationship between Fermi level pinning and the choice of gate dielectric for the combination nickelsilicide as gate electrode and a hafniumoxide as gate dielectric. Terai teaches the amount of Hf-Si bonds at the interface between both materials to determine the threshold of the pMOSFET. Controlling the Si composition in the gate electrode and the Hf content in the gate dielectric can control the number of HfSi bonds and the shift in threshold voltage. The proposed control mechanism is, however, complex and relies on an accurate match between the nickelsilicide and the hafniumoxide. Moreover, the threshold voltage obtained for pMOSFET is still larger than desired.

WO2004/038807 describes a method for forming a MOSFET transistor comprising a gate electrode comprising a nickel germano-silicide layer, resulting from the silicidation of a silicon germanium layer with a composition Si₁₋ₓGeₓ where x is typically comprised between 0,1 and 0,3.

Hence, there is need for a metal having a work function that can be easily tuned. In particular, the work function of the metal must be adjustable so that the metal can be used as a gate electrode material for pMOSFET devices requiring a low threshold voltage. This metal should be easy introducible in a mainstream MOS or CMOS process flow. There is also a need for a gate electrode material that doesn't suffer from Fermi level pinning at the interface between the metal and the high-k dielectric, in particular when the gate dielectric comprises hafnium.

### Summary of the Invention

A MOSFET having a fully germano-silicided gate electrode and a gate dielectric, wherein the fully germano-silicided gate electrode comprises Nickel (Ni), Germanium (Ge), and Silicon (Si), is disclosed.

A MOSFET of the invention comprises a gate electrode and a gate dielectric, said gate electrode comprising (or consisting of) a nickel germano-silicide layer resulting from the nickel silicidation of a silicon-germanium layer having a composition SiₓGe_{y}, wherein x and y are real numbers, wherein 0,4≤y≤0,8, and wherein x+y=1.

In a MOSFET according to the invention, y can be comprised between 0,5 and 0,8, or preferably between 0,55 and 0,8. For example, x can be equal to 0,5 and y equal to 0,5, or preferably x is equal to 0,45 and y equal to 0,55, and even more preferably x is equal to 0,35 and y equal to 0,65.

In a preferred MOSFET of the invention, the gate dielectric comprises hafnium and silicon, and more particularly, the gate dielectric is an HfSiON dielectric.

The invention also relates to a metallic alloy obtainable by a process comprising the step of annealing a nickel containing layer (or preferably a nickel layer) and a silicon-germanium layer having a composition SiₓGe_{y}, wherein x and y are real numbers, wherein x+y=1, and wherein 0,4≤y<1 or 0,5<y<1, preferably 4≤y≤0,8, or 0,5≤y≤0,8, or 0,5<y<0,8. The invention also relates to said process.

For example, for obtaining a metallic alloy according to the invention, x=0,5 and y=0,5, or preferably x=0,45 and y=0,55 and even more preferably x = 0,35 and y =0,65.

A metallic alloy according to the invention can be used as a high work function (i.e. higher than 4,5eV) material.

The invention also relates to a method for forming a pMOSFET, comprising:
- providing a semiconductor substrate having formed thereon at least a gate dielectric, optionally spacers, and source and drain junction regions,
- forming a silicon-germanium layer over said gate dielectric having a composition SiₓGe_{y}, wherein x and y are real numbers, 0,4≤y≤0,8, and x+y=1;
- forming at least on said silicon-germanium layer a metal layer stack comprising (or consisting of) Nickel; and
- annealing said silicon germanium layer and said metal to form a fully metal germano-silicided gate electrode.

In a preferred method of the invention, y is comprised between about 0,5 and about 0,8, preferably 0,5≤y≤0,8 or more preferably 0,5<y<0,8.

For example, in a method according to the invention, x=0,5 and y=0,5, or preferably x=0,45 and y=0,55 and even more preferably x = 0,35 and y =0,65.

Preferably, said gate electrode (4) is (uniformly) deposited by means of a Chemical Vapor Deposition (CVD) process. In particular, SiH₄ and GeH₄ can be used as precursors in said CVD process.

A method according to the invention can further comprise the step of selectively removing the unreacted metal after forming the metal germano-silicided gate electrode.

Preferably, said nickel is provided in a sufficient amount for obtaining a nickel germano-silicide wherein the ratio nickel-to-SiGe is larger than 1, such as Ni₂(SiGe), Ni₃(SiGe)₂, Ni₃₁(SiGe)₁₂, or Ni₃(SiGe).

A method according to the invention can further comprise the steps of forming a dielectric layer over said silicon-germanium layer, the source and drain junction regions and then the step of exposing the said silicon-germanium layer before depositing said metal layer stack.

Also object of the invention is a method for reducing the threshold voltage of a pMOSFET device comprising the step of annealing a nickel containing layer (preferably a nickel layer) and a silicon-germanium layer having a composition SiₓGe_{y}, wherein x and y are real numbers, x+y=1, and wherein y is increased from 0,4 to 0,8, preferably from (about) 0,5 to (about) 0,8 (0,5 can be included or excluded), or more preferably from 0,55 to 0,8.

A method of the invention for reducing the threshold voltage of a pMOSFET device preferably further comprises the step of providing nickel in a sufficient amount for obtaining a nickel germano-silicide wherein the ratio nickel-to-SiGe is larger than 1, such as Ni₂(SiGe), Ni₃(SiGe)₂, Ni₃₁(SiGe)₁₂, or Ni₃(SiGe).

The threshold voltage of the MOSFET can be controlled by controlling the germanium content of the SiₓGe_{y} layer.

The threshold voltage of the MOSFET can further be controlled by controlling the nickel content provided for the annealing step.

In one example, the gate electrode is formed by a reaction between nickel and SiₓGe_{y}, wherein x=0,5 and y=0,5, or preferably x=0,45 and y=0,55 and even more preferably x = 0,35 and y =0,65.

The gate dielectric of this MOSFET comprises hafnium and silicon. Preferably, this gate dielectric is an HfSiON dielectric.

If x = 0.5 and y =0.5, then the absolute value of this threshold voltage is less than 0.55V.

If x = 0.35 and y = 0.65, then the absolute value of this threshold voltage is less than 0.25V.

### Brief Description of the Drawings

Exemplary embodiments are illustrated in referenced figures of the drawings. It is intended that the embodiments and figures disclosed herein be considered illustrative rather than restrictive. Same numerals are used to refer to corresponding features in the drawings.

Figures 1a-d show schematic cross-sections illustrating various steps of a process flow, according to an example.

Figures 2a-e show schematic cross-sections illustrating various steps of a process flow, according to an example.

Figure 3 is a graph that shows the threshold voltage distribution for different gate dielectrics of a fully nickel silicided MOS devices (FUSI) and fully nickel germano-silicided MOS devices (FUSIGE), according to an example.

Figure 4 is a graph that shows the threshold voltage of a fully nickel silicided MOS device (FUSI) and fully nickel germano-silicided MOS devices (FUSIGE), according to an example with varying germanium content.

Figure 5 is a graph that shows the workfunction of a fully nickel germano-silicided MOS device (FUSIGE) according to an example with varying nickel content.

### Detailed Description

A MOSFET having a fully germano-silicided gate electrode and a gate dielectric, wherein the fully germano-silicided gate electrode comprises Nickel (Ni), Germanium (Ge), and Silicon (Si), is disclosed. In one example, the gate electrode is formed by a reaction between nickel and SixGey, where x + y =1. In one example, the gate dielectric of this MOSFET comprises hafnium and silicon. Preferably, this gate dielectric is an HfSiON dielectric.

The threshold voltage of the MOSFET can be controlled by controlling the germanium content of the SixGey layer. If x = 0.5 and y =0.5, then the absolute value of this threshold voltage is less than 0.55V. If x = 0.35 and y = 0.65, then the absolute value of this threshold voltage is less than 0.25V.

The MOSFET can be formed by providing a transistor (a MOSFET) having a semiconductor gate electrode comprising silicon and germanium; forming, at least on part of the semiconductor gate electrode, a metal layer stack comprising Nickel; and transforming the semiconductor gate electrode into a Nickel Germanium Silicon gate electrode. This fully germano-silicided gate electrode is a high work function metallic alloy.

The method can further comprise selectively removing unreacted metal after silicidation of the silicon-germanium.

The method can further comprise forming a dielectric layer over the semiconductor gate electrode and exposing the semiconductor gate electrode before depositing the metal layer stack.

More particularly, a MOSFET of the invention comprises a gate electrode and a gate dielectric, said gate electrode comprising (or consisting of) a nickel germano-silicide layer resulting from the nickel silicidation of a silicon-germanium layer, said silicon-germanium layer having a composition SiₓGe_{y}, wherein x and y are real numbers, wherein 0,4≤y≤0,8, and wherein x+y=1.

In a preferred MOSFET of the invention, the gate dielectric comprises hafnium and silicon, and more particularly, the gate dielectric is an HfSiON dielectric.

A method for manufacturing said MOSFET can comprise the steps of:
- providing at least, formed on a semiconductor substrate, a gate dielectric, optionally spacers, and source and drain junction regions,
- forming a silicon-germanium layer over said gate dielectric, said silicon-germanium layer having a composition SiₓGe_{y}, wherein x and y are real numbers, x+y=1, and wherein 0,4≤y≤0,8, preferably 0,5≤y≤0,8 or 0,5<y<0,8;
- forming at least on said silicon-germanium layer a metal layer stack comprising (or consisting of) Nickel; and
- annealing said silicon-germanium and said metal to form a fully metal germano-silicided gate electrode, more particularly a fully nickel-germano-silicided gate electrode.

The work function of the fully germano-silicided gate electrode can be tuned by varying the Ge content of the semiconductor material.

In particular, by increasing the amount of germanium in said silicon-germanium layer, preferably from 0,4 to 0,8, more preferably from (about) 0,5 to (about) 0,8 (wherein 0,5 can be included or excluded), a method of the invention can be used for reducing the threshold voltage of a pMOSFET.

And by increasing the amount of nickel within said fully nickel-germano-silicided gate electrode, for obtaining nickel-rich-germano-silicided phases such as Ni₃(SiGe)₂, Ni₂(SiGe), Ni₃₁(SiGe)₁₂, and Ni₃(SiGe), said threshold voltage can be further reduced.

Indeed, metal-rich phases such as Ni₃(SiGe)2, Ni₂(SiGe), Ni₃₁(SiGe)₁₂, and Ni₃(SiGe) are particularly suitable as FUSI gate electrode material for pMOS transistors.

In the framework of the present invention, the term "nickel-rich-germano-silicide" or "nickel-rich-germano-silicided phase" refers to the material resulting from the reaction between said nickel and said semiconductor, wherein the ratio nickel-to-semiconductor (i.e. Ni-to-SiGe) is larger than 1.

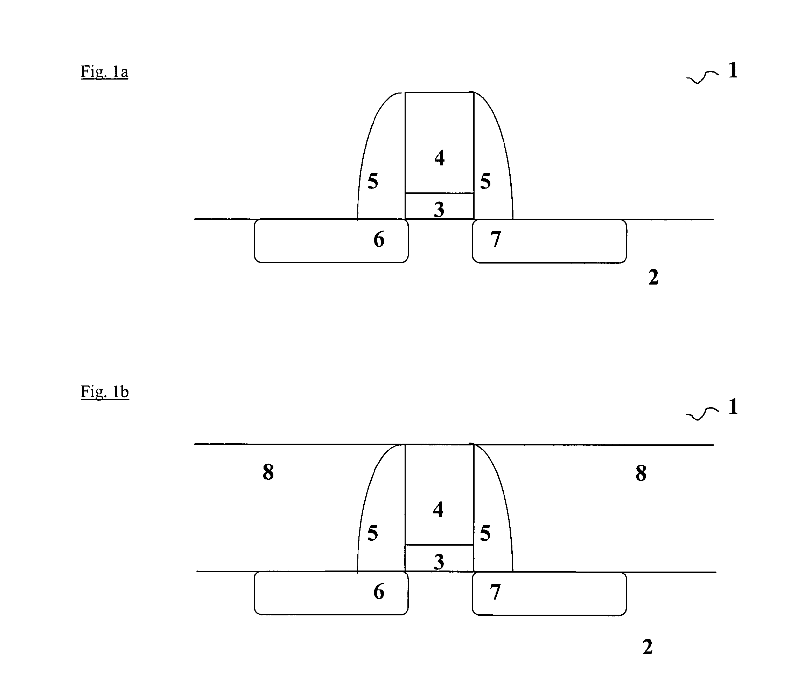

Figures 1a-d schematically illustrate a process flow.

Figure 1a shows a MOSFET device (1) formed on a substrate (2) comprising a gate electrode (4), a gate dielectric (3) in-between the gate electrode (4) and the substrate (2), sidewall spacers (5) formed in a dielectric material adjacent the stack of gate electrode (4) and gate dielectric (3), source (6) and drain (7) junction regions aligned to the gate stack (4, 3) and extending underneath the sidewall spacers (5).

The transistor (1) shown in Figure 1a can be any type of Metal-Oxide-Semiconductor Field-Effect-Transistor (MOSFET), such as a bulk transistor, a Multiple Gate transistor (MuGFET), such as a FinFET device. Preferably the transistor (1) is a pMOSFET.

The gate dielectric (3) can be a siliconoxide, a siliconoxynitride, a high-k dielectric comprising hafnium, such as hafniumoxides hafniumoxyntrides, hafniumsilicates. Preferably, the gate dielectric (3) is a hafniumsiliconoxynitride (also referred to as HfₓSi_{y}ON) such as HfSiON.

The gate electrode (4) comprises silicon and germanium: SiₓGe_{y}, where x + y = 1. Preferably, the gate electrode is formed from Si_{0.5}Ge_{0.5}.

For example, said gate electrode (4) can be (uniformly) deposited by means of a Chemical Vapor Deposition (CVD) process.

The substrate (2) can be a bulk semiconductor substrate, such as a silicon or germanium wafer, a semiconductor-on-insulator substrate, such as Silicon-On-Insulator (SOI) and Germanium-In-Insulator (GeOI).

The sidewall spacers (5) alongside the gate stack of gate electrode (4) and gate dielectric (3) are formed by depositing a conformal layer or stack of layers of dielectric material over the gate stack and by anisotropic etching of this dielectric layer(s) until the gate electrode (4) is exposed as is known in the art. Typically, silicon-oxide, siliconoxynitride, silicon-nitride, or silicon-carbide materials are conformally deposited and etched using a dry etch, such as a reactive ion etch (RIE) or etch plasma.

The source (6) and drain (7) regions can be silicided using a self-aligned silicidation process.

Standard semiconductor processes as known and appreciated by any person skilled in the art can be carried out for forming said gate dielectric (3), said sidewall pacers (5) and said source (6) and drain (7) regions.

In Figure 1b, a dielectric layer stack (8) is deposited over the MOSFET device. This layer can be a silicon-oxide layer deposited by Chemical Vapor Deposition (CVD). This dielectric layer stack (8) is planarized by Chemical Mechanical Polishing (CMP) until the gate electrode (4) is exposed. This dielectric layer stack (8) shields the source (6) and drain (7) regions when forming the fully silicided gate electrode (10). However, this process step is optional and can be postponed until the fully silicided gate (10) is formed.

In this process, optional silicidation of the gate electrode (4) can be done together with the silicidation of the source (6) and drain (7) regions.

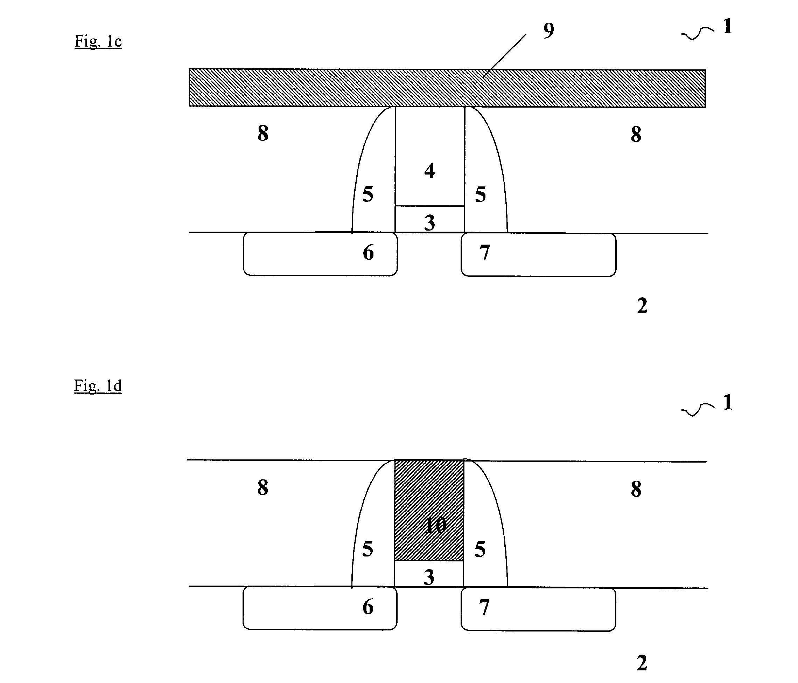

In Figure 1c, a layer (9) of silicidation metal(s) is deposited overlying at least the gate electrode (4). This layer of silicidation metal(s) comprises nickel. Preferably, the layer (9) of silicidation metal(s) is a layer of nickel.

In Figure 1d, the semiconductor material(s) of the gate electrode (4) and the silicidation metal(s) (9) have reacted in a self-aligned process to form a fully silicided gate electrode (10). Sufficient thermal energy is provided to have the electrode comprising Si and Ge react with the silicidation metal comprising nickel and to form a fully germano-silicided gate electrode. Preferably Si_{0.5}Ge_{0.5} is used to form the gate electrode (4) and nickel is used as silicidation metal (9) and a nickel-silicon-germanium Ni₃(SiGe)₂ (10) is formed.

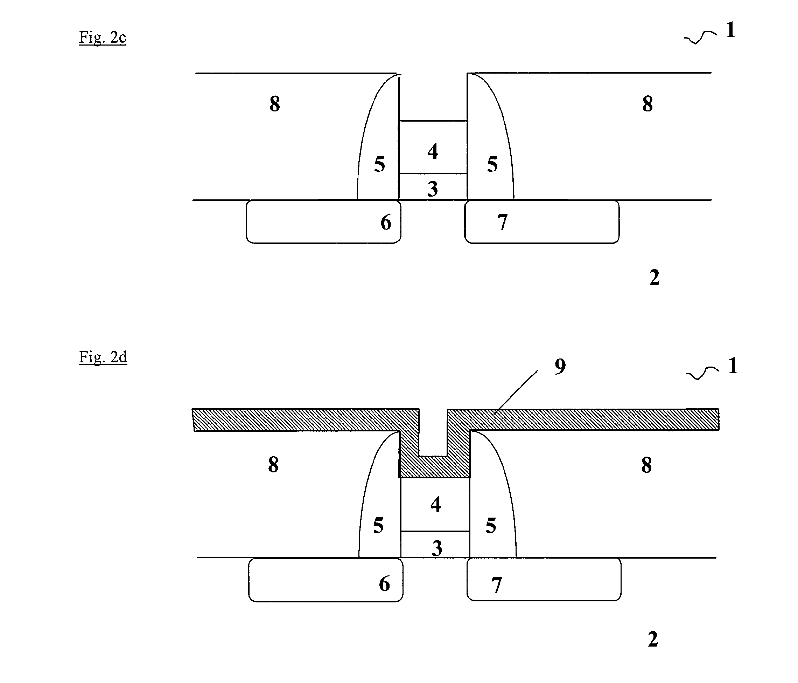

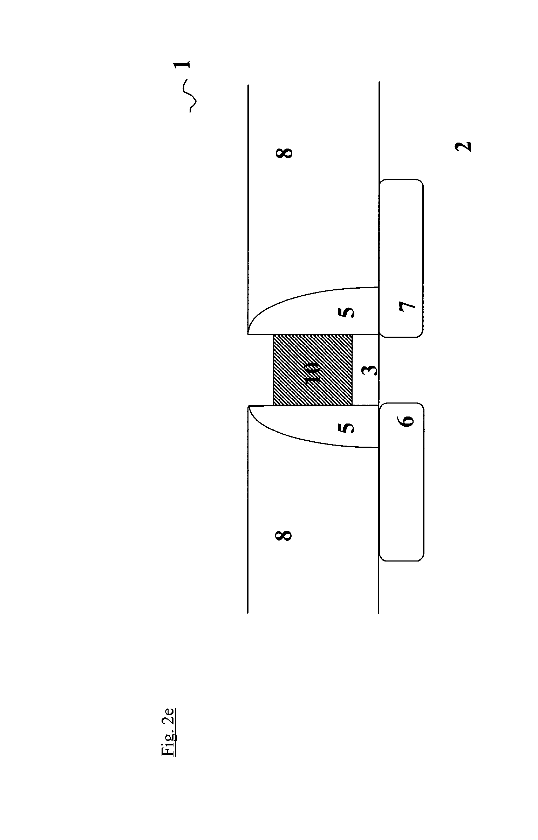

A fully germano-silicided pMOSFET is formed as illustrated by Figures 2a-e.

HfₓSi_{y}ON layers are uniformly deposited using a Metal Organic Chemical Vapor Deposition (MOCVD) on an n-type substrate (2) to form the gate dielectric (3). The thickness and the composition of this dielectric layer is varied from one substrate to another: about 2 nm HfSiON with Hf/Si ratio of about 23/77, about 3 nm HfSiON with Hf/Si ratio of about 53/47 and about 3 nm HfSiON with Hf/Si ratio of about 65/35.

A layer of about 100 nm undoped Si_{0.5}Ge_{0.5} is uniformly deposited over a dielectric layer on a substrate (2) using SiH₄ and GeH₄ as precursor in a Chemical Vapor Deposition (CVD) process to form the gate electrode (4).

An oxide layer (11) of about 60 nm is deposited on the Si_{0.5}Ge_{0.5} layer.

The stack of HfSiON/SiGe/oxide is patterned to form the gate stack (4, 3) of a pMOSFET.

Source (6) and drain (7) regions are formed self-aligned to the gate stack (4, 3) by ion implantation.

Nitride sidewall spacers (5) are formed yielding the device (1) shown in Figure 2a.

The silicon-germanium gate (4) and the source (6)/drain (7) junction regions are silicided independently allowing the formation of a fully germano-silicided gate electrode on the one hand and a shallow junction silicide on the other hand.

The oxide layer (11) on top of the Si_{0.5}Ge_{0.5} gate electrode (4) prevents the Si_{0.5}Ge_{0.5} from being silicided during silicidation of the source (6) and drain (7) junction regions.

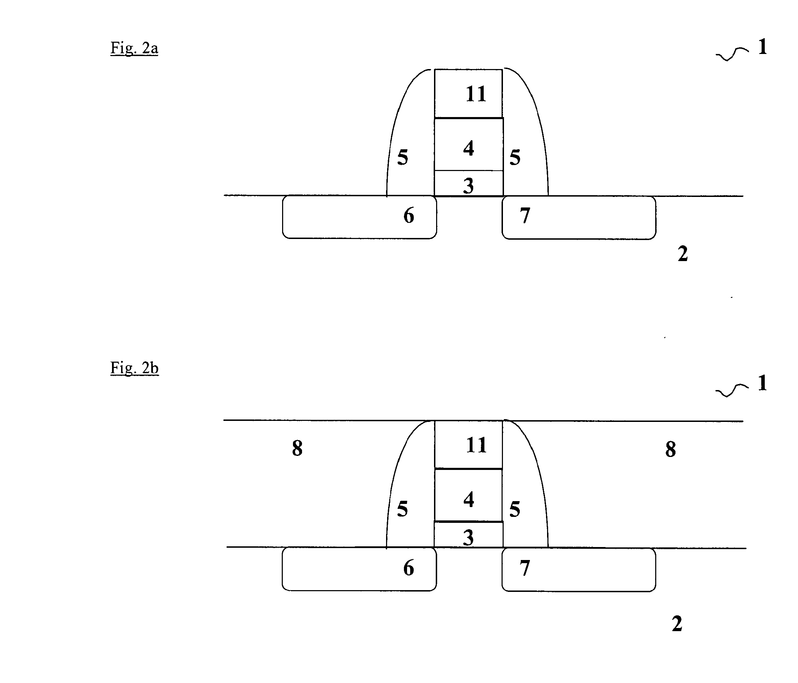

A thick layer of PSG oxide (8) is deposited and planarized using CMP yielding the device (1) shown in Figure 2b.

The oxide layer (11) on top of the SiGe gate electrode serves as a polishing stop layer when planarizing the PSG layer (8).

The Si_{0.5}Ge_{0.5} of the gate electrode (4) is exposed by removing the oxide layer (11) on top yielding the device (1) shown in Figure 2c.

About 80 nm of nickel (9) is deposited yielding the device (1) shown in Figure 2d.

Thereafter, one Rapid Thermal Processing (RTP) step is performed in a nitrogen atmosphere for about 30s at 450°C to form a nickel germano-silicide (10) Ni₃(SiGe)₂.

Remaining unreacted nickel is selectively removed using a wet etch mixture comprising HCl/ and SPM, resulting in the FUGESI device (1) shown in Figure 2e having a fully nickel germano-silicided gate electrode (10).

Table 1 below gives a comparison between the silicon-germanium gate and a silicon gate, both being fully silicided using nickel as a silicidation metal. The equivalent electrical thickness (EOT), i.e., the dielectric thickness extracted from capacitance-voltage measurement, and the flatband voltage (V_{fb}) were obtained on a capacitor of 1um by 1um. Compared to their fully silicided (FUSI) counterparts, the fully germano-silicided (FUGESI) devices show a positive flatband voltage shift of about 210mV independently of the composition of the HfSiON dielectric layer and for a gate electrode (4) containing 50% germanium.

**Table 1**

| HfₓSi_{y}ON layer | | Fully germano-silicided (FUGESI) | | Fully silicided (FUSI) | |
|---|---|---|---|---|---|
| Thickness (nm) | Hf/Si ratio | EOT (nm) | Vfb (V) | EOT (nm) | V_{fb} (V) |
| 2 | 23/77 (~8 %Hf) | 1.33 | 0.59 | 1.31 | 0.38 |
| 3 | 53/47 (~17%Hf) | 1.36 | 0.57 | 1.35 | 0.35 |
| 3 | 65/35 (~22%) | 1.18 | 0.56 | 1.15 | 0.35 |

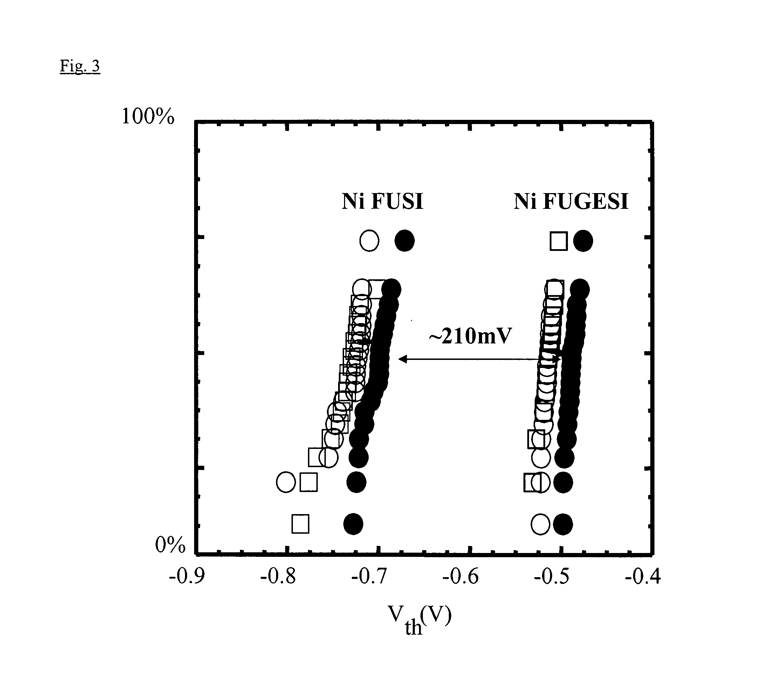

This difference in electrical characteristics is also illustrated in Figure 3, which shows the distribution of threshold voltage Vₜₕ across the wafer for FUSI (left) and FUSIGE (right) for all HfₓSi_{y}ON splits of Table 1: 2 nm HfₓSi_{y}ON and about 8% Hf (solid circles), 3 nm HfₓSi_{y}ON and about 17% Hf (open circles), 3 nm HfₓSi_{y}ON and about 22% Hf (open squares).

The data of the FUSI devices shows a threshold voltage at about -0.73V, which shifts to more negative values with increasing Hf content in the gate dielectric.

The data of the FUSIGE devices shows a threshold voltage at about -0.52V, which shifts to more negative values with increasing Hf, content in the gate dielectric.

For each split there is a shift in threshold voltage of about 210mV between FUSI and FUSIGE devices.

For a gate stack of a fully nickel germano-silicided gate electrode (10) and a gate dielectric (4) of 2nm HfₓSi_{y}ON and about 8% Hf, the threshold voltage is about -0.5V, meeting the requirements for low-power devices.

Another advantage of the fully germano-silicided gate electrode is that pMOSFET devices with the nickel-silicon-germanium gate electrode have a threshold voltage lower compared to similar pMOSFET devices with a nickel-silicon gate electrode.

Furthermore, the volume expansion coefficient of the nickel-silicon-germanium formed is similar to the volume expansion coefficient of its nickel silicide counterpart. For the fully germano-silicided gate MOSFET, the phase of the fully silicided gate electrode (10) was Ni₃(SiGe)₂, while the phase of a similarly processed pMOSFET but using a silicon gate was Ni₃Si₂. Thus, the fully germano-silicided gate electrode allows the formation of pMOSFET devices having a lower threshold voltage by substitution of the silicon gate electrode by a silicon-germanium electrode, without the need to take additional measures in order to accommodate for the changes in the volume of the gate electrode (4) caused by the silicidation process.

Implementation of alternative metals, such as PtSi or Ni₃Si, as a p-type low threshold metal gate electrode would require additional measures as these silicidation process have a volume expansion coefficient of 1.7 and 2.1 respectively.

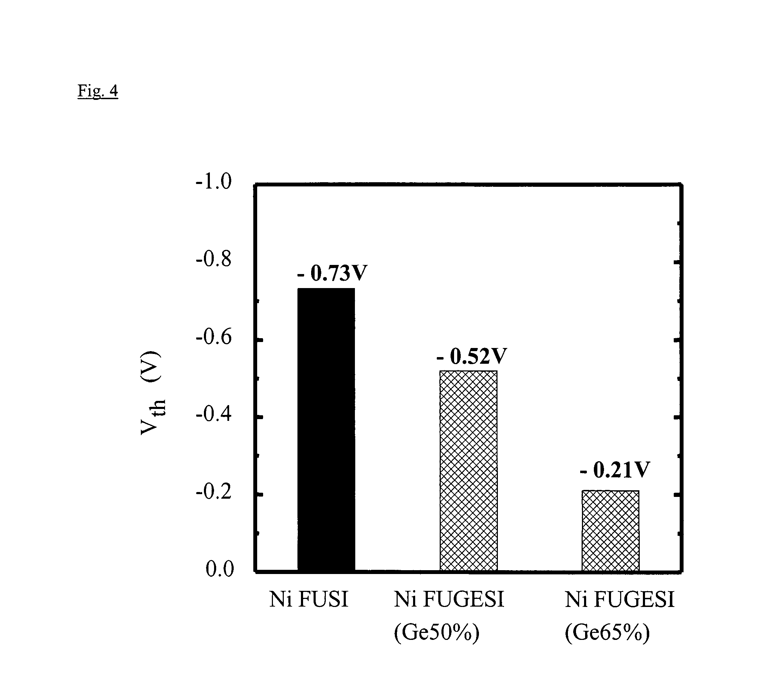

Another advantage of the fully germano-silicided gate electrode is illustrated in Figure 4. The threshold voltage Vₜₕ of MOSFET devices having a fully germano-silicided gate electrode can be controlled by selecting the germanium content (y) of the SiₓGe_{y} gate electrode (4) before silicidation. The threshold voltages shown in Figure 4 are obtained on pMOS devices of 1µm by 1µm having a gate dielectric of 3nm HfSiON with about 22% Hf.

For a MOS device with a Ni FUSI gate electrode, formed by silicon and nickel, a threshold voltage of about - 0.73V was measured (black rectangle).

For pMOS devices with a Ni FUSIGE gate electrode (10), formed by silicon, germanium and nickel, the threshold voltage was about -0.52V for about 50% germanium content in the SiₓGe_{y} gate electrode (4) (y = 0.5).

The threshold voltage is further decreased to about - 0.21V for about 65% germanium content in the SiₓGe_{y} gate electrode (4) (y = 0.65).

Thus, a fully germano-silicided gate electrode allows the threshold voltage of a MOSFET to be controlled. In particular, the threshold voltage of a pMOSFET can be controlled by controlling the amount of germanium in the silicon-germanium gate-electrode before silicidation. The amount of germanium in the SiₓGe_{y} gate electrode can vary between 0 < y < 1, preferably between 0.4 ≤ y ≤ 0.8.

In another example a fully germano-silicided pMOSFET is formed. In this example the ratio silicon-to-germanium in the silicon-germanium layer is kept constant, while the thickness of the nickel layer deposited on top of this silicon-germanium layer is varied. By varying the ratio nickel to silicon-germanium, the composition of the FUSIGE gate electrode can be varied and various nickel-germanium-silicon phases can be formed, each phase having its corresponding work function. The process sequence for forming this pMOSFET is similar to the process sequence illustrated by Figures 2a-e.

HfₓSi_{y}ON layers are uniformly deposited using a Metal Organic Chemical Vapor Deposition (MOCVD) on an n-type substrate (2) to form the gate dielectric (3). The thickness and the composition of this dielectric layer is about 2 nm HfSiON with Hf/Si ratio of about 23/77.

A layer of about 100 nm undoped Si_{0.5}Ge_{0.5} is uniformly deposited over a dielectric layer on a substrate (2) using SiH₄ and GeH₄ as precursor in a Chemical Vapor Deposition (CVD) process to form the gate electrode (4).

An oxide layer (11) of about 60 nm is deposited on the Si_{0.5}Ge_{0.5} layer.

The stack of HfSiON/SiGe/oxide is patterned to form the gate stack (4, 3) of a pMOSFET.

Source (6) and drain (7) regions are formed self-aligned to the gate stack (4, 3) by ion implantation.

Nitride sidewall spacers (5) are formed yielding the device similar to the device (1) shown in Figure 2a.

The silicon-germanium gate (4) and the source (6)/drain (7) junction regions are silicided independently allowing the formation of a fully germano-silicided gate electrode on the one hand and a shallow junction silicide on the other hand.

The oxide layer (11) on top of the Si_{0.5}Ge_{0.5} gate electrode (4) prevents the Si_{0.5}Ge_{0.5} from being silicided during silicidation of the source (6) and drain (7) junction regions.

A thick layer of PSG oxide (8) is deposited and planarized using CMP yielding the device similar to the device (1) shown in Figure 2b.

The oxide layer (11) on top of the SiGe gate electrode serves as a polishing stop layer when planarizing the PSG layer (8).

The Si_{0.5}Ge_{0.5} of the gate electrode (4) is exposed by removing the oxide layer (11) on top yielding the device similar to the device (1) shown in Figure 2c.

Respectively 120 nm, 80 nm or 60 nm of Nickel (9) is deposited yielding the device similar to the device (1) shown in Figure 2d.

Thereafter, one Rapid Thermal Processing (RTP) step is performed in a nitrogen atmosphere for about 30s at 450°C to form a nickel germano-silicide (10) with respective phase Ni₂(SiGe) (starting from 120 nm Ni), Ni₃(SiGe)₂ (starting from 80 nm Ni) and NiSiGe (starting from 60 nm Ni).

Remaining unreacted nickel is selectively removed using a wet etch mixture comprising HCl/ and SPM, resulting in the FUGESI device similar to the device (1) shown in Figure 2e having a fully nickel germano-silicided gate electrode (10).

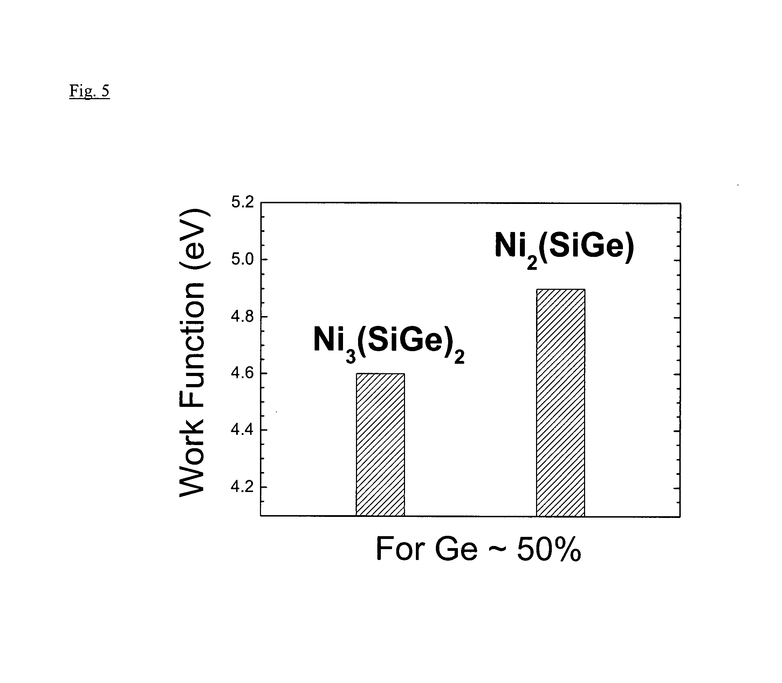

Figure 5 is a graph showing the workfunction of fully nickel germano-silicided MOS devices (FUSIGE) with different nickel germanium silicon phases illustrating the shift in work function, and hence in threshold voltage, with varying nickel content.

When increasing the nickel content, a Ni₂(SiGe) phase can be obtained having a work function of about 4.9eV which is about 300mV higher than the work function of about 4.6eV corresponding to the Ni₃(SiGe)₂ having a lower nickel content. This 300mV shift in work function will be reflected in a corresponding shift in threshold voltage of the pMOSFET.

When decreasing the nickel content, a NiSiGe phase (starting from 60 nm Ni) can be obtained having a work function of about 4.55eV, which is about 50mV lower than the workfunction of about 4.6eV for the Ni₃(SiGe)₂ phase.

## Claims

1. A MOSFET comprising a gate electrode and a gate dielectric, said gate electrode comprising a nickel germano-silicide layer resulting from the nickel silicidation of a silicon germanium layer having a composition SiₓGe_{y}, wherein x and y are real numbers, 0,4≤y≤0,8, and x+y=1.

2. A MOSFET according to claim 1, wherein y is comprised between 0,5 and 0,8, or preferably between 0,55 and 0,8.

3. A MOSFET according to claim 2, wherein x=0,5 and y=0,5, or preferably x=0,45 and y=0,55.

4. A MOSFET according to claim 2, wherein x=0,35 and y=0,65.

5. A MOSFET according to any of claims 1 to 4, wherein the gate dielectric comprises hafnium and silicon.

6. A MOSFET according to claim 5, wherein the gate dielectric is an HfSiON dielectric.

7. A metallic alloy obtainable by annealing nickel and a silicon germanium layer having a composition SiₓGe_{y}, wherein x and y are real numbers, 0,4≤y≤0,8, and x+y=1.

8. A metallic alloy according to claim 7, wherein 0,5≤y≤0,8 or preferably 0,5<y<0,8.

9. A metallic alloy according to claim 7 or 8, wherein x=0,5 and y=0,5, or preferably x=0,45 and y=0,55.

10. A metallic alloy according to claim 7 or 8, wherein x = 0,35 and y =0,65.

11. Use of a metallic alloy according to any of claims 7 to 10 as a high work function (i.e. higher than 4,5eV) material.

12. A method for forming a pMOSFET, comprising:
- providing a semiconductor substrate (2) having formed thereon at least a gate dielectric (3), optionally spacers (5), and source (6) and drain (7) junction regions,
- forming a silicon germanium layer over said gate dielectric (3) having a composition SiₓGe_{y}, wherein x and y are real numbers, 0,4≤y≤0,8, and x+y=1;
- forming at least on said silicon germanium layer a metal layer stack comprising Nickel; and
- annealing said silicon germanium and said metal to form a fully metal germano-silicided gate electrode.

13. A method according to claim 12, wherein 0,5≤y≤0,8 or preferably 0,5<y<0,8.

14. A method according to claim 12 or 13, wherein x=0,5 and y=0,5, or preferably x=0,45 and y=0,55.

15. A method according to claim 12 or 13, wherein x = 0,35 and y =0,65.

16. A method according to any of claims 12 to 15 further comprising selectively removing the unreacted metal after forming the metal germano-silicided gate electrode.

17. A method according to any of claims 12 to 16, wherein the metal layer stack is a nickel layer.

18. A method according to claim 17 wherein said nickel is provided in a sufficient amount for obtaining a nickel germano-silicide wherein the ratio nickel-to-SiGe is larger than 1, such as Ni₂(SiGe), Ni₃(SiGe)₂, Ni₃₁(SiGe)₁₂, or Ni₃(SiGe).

19. A method according to any of claims 12 to 18 further comprising forming a dielectric layer over said silicon germanium layer, the source and drain junction regions and then exposing the said silicon germanium layer before depositing the metal layer stack.

20. A method for forming a metallic alloy comprising the step of annealing nickel and a silicon-germanium layer having a composition SiₓGe_{y}, wherein x and y are real numbers, 0,4≤y≤0,8, and x+y=1.

21. A method according to claim 20, wherein 0,5≤y≤0,8 or preferably 0,5<y<0,8.

22. A method according to claim 21, wherein x=0,5 and y=0,5, or preferably x=0,45 and y=0,55.

23. A method according to claim 21, wherein x = 0,35 and y =0,65.

24. A method for reducing the threshold voltage of a pMOSFET device comprising the step of annealing nickel and a silicon germanium layer having a composition SiₓGe_{y}, wherein x and y are real numbers, x+y=1, and wherein y is increased from 0,4 to 0,8, preferably from 0,5 to 0,8, or more preferably from 0,55 to 0,8.

25. A method according to claim 24 further comprising the step of providing nickel in a sufficient amount for obtaining a nickel germano-silicide wherein the ratio nickel-to-SiGe is larger than 1, such as Ni₂(SiGe), Ni₃(SiGe)₂, Ni₃₁(SiGe)₁₂, or Ni₃(SiGe).

26. A method according to claim 25, wherein x=0,5 and y=0,5, or preferably x=0,45 and y=0,55.

27. A method according to claim 25, wherein x=0,35 and y=0,65.
